# FASCICULE DE BREVET EUROPEEN

(11) **EP 1 160 990 B1**
(45) Date de publication et mention de la délivrance du brevet: **15.10.2003**
(21) Numéro de dépôt: 01401038.3
(22) Date de dépôt: 24.04.2001
(51) Int. Cl.: H03M 13/43, B60C 23/04

(54) **Procédé et système de détection de l'état de gonflage de pneumatiques d'un véhicule automobile**
Reifendruckstand Detektionsverfahren und System für Kraftfahrzeugen
Automobile vehicle tyre inflating state detection method and system

(30) Priorité: 30.05.2000 FR 0006897
(43) Date de publication de la demande: 05.12.2001
(73) Titulaire: Peugeot Citroen Automobiles SA, 92200 Neuilly sur Seine (FR)
(72) Inventeur: Le Bourgeois, François-Xavier M., 92400 Courbevoie (FR); Rigaud, Stéphane M., 92350 Le Plessis-Robinsson (FR); Ripoche, Damien M., 92370 Chaville (FR)
(74) Mandataire: Grynwald, Albert

(56) Documents cités:
- WO-A-96/06747
- US-A- 4 067 235
- US-A- 5 483 827
- US-A- 5 603 013
- PATENT ABSTRACTS OF JAPAN vol. 016, no. 290 (M-1272), 26 juin 1992 (1992-06-26) & JP 04 078605 A (OMRON CORP), 12 mars 1992 (1992-03-12)
- PATENT ABSTRACTS OF JAPAN vol. 1998, no. 05, 30 avril 1998 (1998-04-30) & JP 10 019710 A (YOKOHAMA RUBBER CO LTD:THE), 23 janvier 1998 (1998-01-23)

## Description

L'invention est relative à un procédé et un dispositif ou système de détection de la pression de gonflage d'un pneumatique équipant une roue d'un véhicule automobile.

La pression de gonflage des pneumatiques d'un véhicule automobile doit rester dans des limites prédéterminées pour que la sécurité de la conduite soit assurée. En particulier, la sécurité n'est pas assurée correctement quand la pression d'un ou plusieurs pneumatiques descend au-dessous d'un seuil prédéterminé.

En l'absence de détecteur de pression, ce défaut ne se détecte en général que par un comportement anormal du véhicule, c'est-à-dire seulement quand la conduite devient particulièrement dangereuse.

C'est pourquoi on commence à équiper les véhicules de systèmes de détection de pression des pneumatiques qui permettent de déterminer la pression de chaque pneumatique et son évolution. Ainsi, en cas de crevaison, la diminution progressive de pression est détectée rapidement, ce qui permet d'informer le conducteur de l'incident, avant même que la crevaison ne soit perceptible sur la conduite du véhicule. De même, le conducteur est informé sans délai d'un sous-gonflage.

Pour la détection de la pression de chaque pneumatique, on prévoit sur chaque roue un capteur de pression, qui est, par exemple, solidaire de la valve de gonflage. Ce capteur est associé à un circuit de conversion et à une antenne pour émettre dans le domaine des fréquences UHF un signal représentant, outre la pression du pneumatique correspondant, un code identificateur de roue et éventuellement d'autres informations.

Ce signal est en général de type numérique. Il est capté dans le véhicule, par exemple à l'aide d'une antenne disposée à proximité du volant.

La transmission des signaux de l'émetteur de chaque roue vers le récepteur à l'intérieur du véhicule ne s'effectue pas dans des conditions optimales, en raison de l'obstacle constitué par le véhicule même et de parasites, tels que ceux engendrés par les bougies du moteur et d'autres systèmes électroniques du véhicule.

Pour remédier aux défauts de transmission de l'émetteur vers le récepteur, il est connu d'augmenter le bilan de liaison de cette transmission, c'est-à-dire de prévoir une puissance d'émission et/ou de réception importante, et/ou de disposer le récepteur à proximité des émetteurs. Ces dispositions sont particulièrement onéreuses et contraignantes.

Pour remédier à cet inconvénient, chaque mot envoyé par l'émetteur de roue vers le récepteur dans le véhicule peut être répété afin que la redondance permette de s'affranchir des parasites liés à la transmission. Par exemple, chaque émetteur de roue transmet des informations sous forme de trames comprenant un nombre déterminé de mots identiques dont chacun comprend notamment la valeur de la pression et un code identificateur de la roue. Dans ce cas, on peut considérer qu'un mot a été correctement reçu lorsqu'on a pu décoder deux mots identiques.

Il est également à noter que le brevet US 5 483 827 décrit un procédé de correction d'un signal de pression de pneu transmis, utilisant des codes correcteurs d'erreur. En outre, le brevet US 5 603 013 décrit un procédé de correction de signaux retransmis par logique majoritaire, c'est-à-dire en détectant pour chaque bit de poids donné la valeur la plus fréquemment reçue.

Mais on a constaté que ce procédé ne donnait pas de résultat satisfaisant.

Ainsi, l'invention résulte de la constatation que malgré les émissions redondantes, il faut en général plusieurs trames avant de détecter de façon sûre le mot transmis par l'émetteur de roue si le critère de réception correcte du signal transmis par un émetteur de roue est constitué par la réception de deux mots identiques d'une même trame. Étant donné que pour économiser l'énergie les trames ne peuvent être émises en permanence, les émissions de deux trames successives sont séparées par une durée non négligeable, par exemple de l'ordre d'une minute. La réception sur plusieurs trames signifie donc qu'il s'écoule un délai non négligeable entre l'émission et la détection.

En outre, la détection n'est pas fiable.

Le retard et la mauvaise qualité de détection ne sont pas favorables à la sécurité.

L'invention remédie à ces inconvénients.

Elle est basée sur la constatation que le défaut de fiabilité de la réception est dû à une modulation qui a pour origine la rotation de l'émetteur. En effet, cette rotation provoque une variation de la distance de l'émetteur au récepteur ainsi qu'une variation de la position du diagramme de l'antenne d'émission par rapport au diagramme de l'antenne de réception.

A partir d'une certaine vitesse, la rotation de la roue entraîne pour une grande partie des mots émis, dont chacun a par exemple une durée de 25 ms, un affaiblissement d'une partie de chaque mot. Cet affaiblissement est en général tel que la partie concernée du mot, par exemple un ou deux bits, est reçue pratiquement au niveau du bruit. La partie concernée du mot n'est donc pas détectée. Le mot est donc détérioré.

On a également observé que, dans une même trame, les parties altérées des mots ne se trouvent pratiquement jamais au même endroit.

L'invention consiste à reconstituer le mot complet à partir des parties des mots d'une trame ou séquence qui sont correctement reçues.

Dans un mode de réalisation, les mots d'une même trame ou séquence sont enregistrés dans une ou plusieurs mémoires et les bits de même poids sont soumis à une opération OU logique. Dans ces conditions, la partie dégradée d'un mot reçu qui est soit constituée par une absence d'information, soit par un ou plusieurs zéros, est remplacée par les bits corrects qui se trouvent dans les autres mots qui ne sont pas dégradés au même endroit.

La localisation temporelle des chiffres binaires (bits) de chaque mot ne pose pas de problème particulier, car l'intervalle séparant deux mots successifs a une valeur prédéterminée (constante ou non).

Ainsi, la présente invention prévoit un procédé de décodage, à bord d'un véhicule automobile, de mots numériques transmis par un émetteur solidaire d'une roue et représentant la pression du pneumatique correspondant. L'émetteur produisant une suite déterminée de mots identiques, et chaque mot pouvant présenter une partie dégradée, on reconstitue le mot à partir des parties restées correctes des mots identiques.

Selon une réalisation, le (ou les) chiffre(s) binaire(s) de la partie dégradée est (sont) à zéro.

Selon une réalisation, on soumet les bits de même poids des mots d'une même suite de mots identiques à une opération OU logique.

L'opération OU logique est, par exemple, effectuée avec le mot précédent à l'apparition de chaque mot décodé, le résultat de l'opération étant gardé en mémoire pour être soumis à la même opération avec le mot décodé suivant.

En variante, les mots successifs sont gardés en mémoire et l'opération OU logique est effectuée sur l'ensemble des mots gardés en mémoire.

Selon une réalisation, les mots sont transmis en séquences ou trames séparées, chaque trame comportant un nombre déterminé de mots identiques séparés par des intervalles prédéterminés.

La détection des mots identiques d'une roue peut alors être effectuée à partir des mots séparés par des intervalles prédéterminés.

Dans ce cas, un mot apparaissant après un mot précédent en un temps différent d'un intervalle prédéterminé est considéré comme le premier mot d'une autre roue.

Selon une réalisation, le premier mot de chaque trame est utilisé pour synchroniser le décodage.

L'invention prévoit en outre un système de détection de l'état de gonflage des pneumatiques d'un véhicule automobile dans lequel chaque pneumatique est équipé d'un capteur de pression et d'un émetteur. L'émetteur transmettant des mots numériques identiques représentant la pression du pneumatique, vers un récepteur à bord du véhicule, et le récepteur détectant le mot transmis à partir des informations redondantes émises par l'émetteur de la roue, pour le décodage, le récepteur comprend un dispositif pour reconstituer le mot à décoder à partir des informations correctes des différents mots reçus.

Selon une réalisation, le système comprend un dispositif pour effectuer une opération OU logique sur les bits de même poids de chaque mot reçu au cours d'une même séquence.

D'autres caractéristiques et avantages de l'invention apparaîtront avec la description de certains de ses modes de réalisation, celle-ci étant effectuée en se référant aux dessins ci-annexés sur lesquels :
la figure 1 est un diagramme montrant une trame de huit mots transmis par un émetteur,
la figure 2 est un diagramme à échelle de temps dilatée par rapport au diagramme de la figure 1 montrant l'enveloppe d'un mot reçu,
la figure 3 est un diagramme analogue à celui de la figure 2, montrant l'enveloppe du mot décodé par le récepteur,
la figure 4 est un organigramme montrant un exemple d'un procédé de décodage conforme à l'invention, et
la figure 5 montre un exemple de mot transmis par un capteur de pression de pneumatique de roue d'un véhicule automobile.

Dans l'exemple que l'on va décrire en relation avec les figures, un véhicule automobile comporte pour chaque roue, éventuellement aussi la roue de secours, un détecteur de pression qui émet vers un récepteur à bord du véhicule, au voisinage du volant de direction, des trames ou séquences de durée une seconde qui sont composées de huit mots identiques 10₁ à 10₈ dont chacun a une durée T = 25 ms.

Deux mots successifs sont séparés par une durée prédéterminée qui est un multiple de la durée de chaque mot. Ainsi les mots 10₁ et 10₂ sont séparés par une durée 6T. De même, l'intervalle séparant les mots 10₂ et 10₃ est de 6T. L'intervalle entre les mots 10₃ et 10₄ ainsi qu'entre les mots 10₄ et 10₅ est de 8T. L'intervalle entre les mots 10₅ et 10₆ est de 6T, celui entre les mots 10₆ et 10₇ est de 8T, et, enfin, entre les mots 10₇ et 10₈ l'intervalle est de 4T.

Chaque mot comporte 45 bits. Chaque bit est représenté par un signal numérique modulé en largeur d'impulsion, un "0" étant représenté par un rapport cyclique d'un tiers (signal haut ayant une durée d'un tiers de la période d'un bit), tandis qu'un "1" est représenté par un rapport cyclique de deux tiers, c'est-à-dire que le signal haut dure les deux tiers de la période du bit.

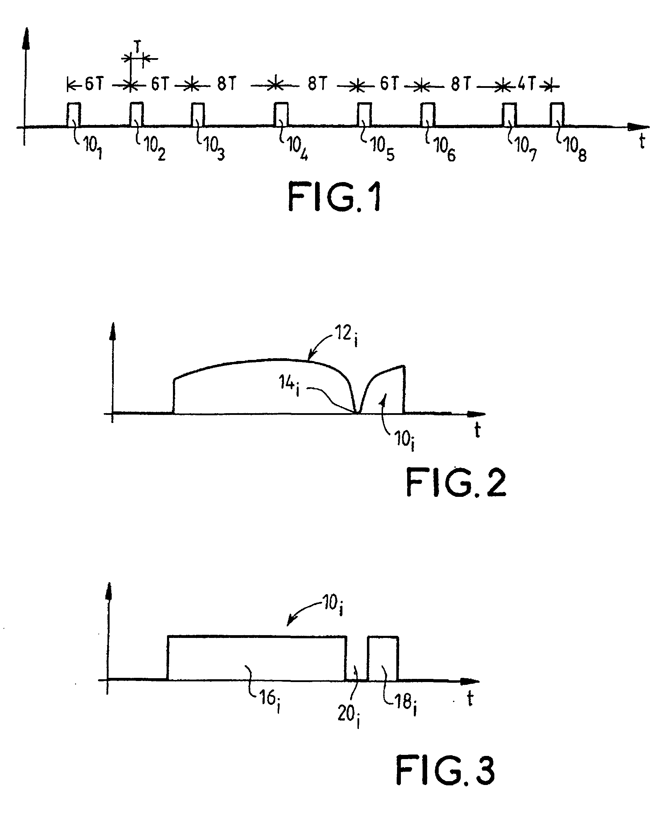

La figure 2 représente l'enveloppe 12ᵢ d'un mot numérique 10ᵢ tel que reçu à l'intérieur du véhicule. On constate un affaiblissement prononcé 14ᵢ qui descend au niveau du bruit du récepteur. Dans ces conditions, comme montré sur le diagramme de la figure 3, le mot décodé 10ᵢ comprend deux parties 16ᵢ et 18ᵢ séparées par une partie dégradée 20ᵢ. Les bits de la partie dégradée 20ᵢ sont, dans l'exemple, tous considérés comme des zéros.

Étant donné que la position des bits dégradés 20ᵢ varie d'un mot à un autre, c'est-à-dire que cette position n'est pratiquement jamais la même, on peut reconstituer le mot correct à partir des parties non dégradées 16ᵢ et 18ᵢ des sept ou huit mots d'une trame reçue.

Le premier mot 10₁ est utilisé pour la synchronisation et, éventuellement, pour l'information qu'il contient.

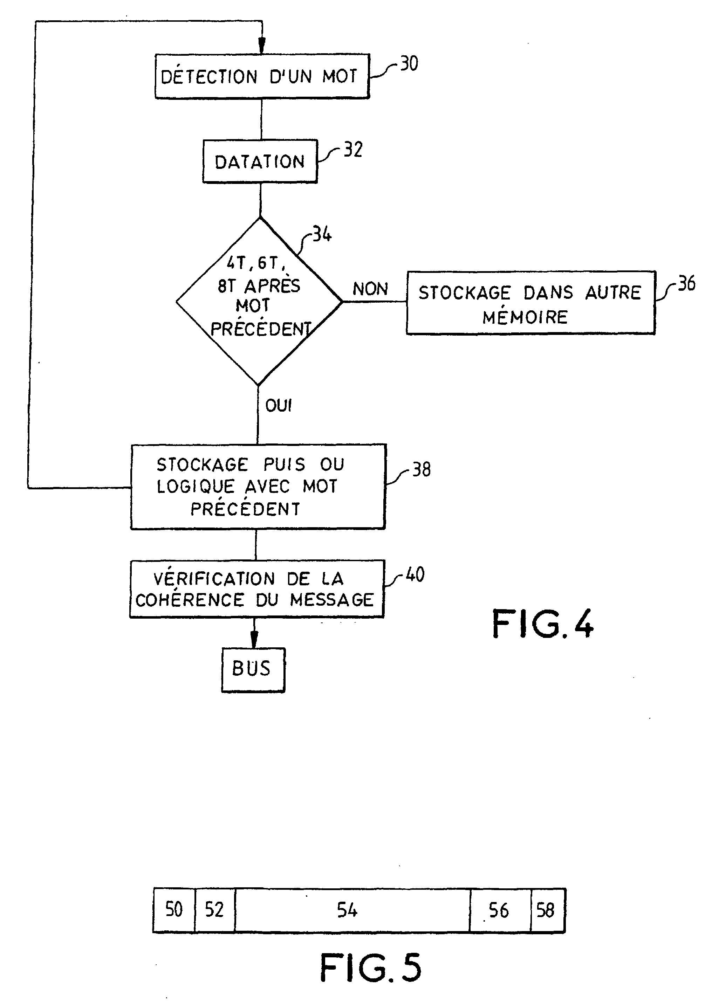

La figure 4 est un organigramme illustrant un procédé de reconstitution d'un mot complet au cours d'une trame.

Au cours d'une première étape 30, on détecte un mot et, au cours d'une seconde étape 32, on effectue une datation de l'apparition du mot après le mot précédent. Au cours d'une troisième étape 34, on détermine si la datation déterminée au cours de la seconde étape 32, est égale à 4T, 6T ou 8T. S'il n'en est pas ainsi, il s'agit du premier mot d'une autre roue et on le stocke dans une mémoire, comme représenté par l'étape 36. Si la durée est égale à 4T, 6T ou 8T, il s'agit alors de l'un des mots 10₂ à 10₈. On le stocke dans une mémoire distincte ou dans la même mémoire que le premier mot : étape 38.

S'il s'agit du mot 10₃, 10₄, ..., 10₈, les bits de même poids du mot ainsi décodé et du mot précédemment mis en mémoire sont soumis à une opération OU logique et le résultat de l'opération est gardé en mémoire pour être soumis à la même opération avec le mot décodé suivant. Le mot ainsi reconstitué avec l'ensemble des mots de la trame est soumis à une vérification d'erreur classique ou vérification de la cohérence du message (étape 40). Si les deux bits de vérification indiquent une absence d'erreur, le mot ainsi obtenu est donc correct et il est mis sur un bus de communication pour traitement, par exemple dans un ordinateur de bord.

L'opération OU logique fournit un "1" si les deux bits concernés ont la valeur 1. Elle fournit la valeur "1" quand l'un des bits est "0" et quand l'autre bit est à "1", et elle fournit la valeur "0" quand les deux bits sont à "0". Ainsi quand deux bits de même poids de deux mots différents ont des valeurs différentes, c'est le "1" qui l'emporte, le "0" correspondant à un affaiblissement 20ᵢ indésiré.

En variante, au lieu d'effectuer l'opération OU logique à l'apparition de chaque mot décodé, on stocke les sept ou huit mots et on effectue l'opération OU logique sur les bits de même poids de ces sept ou huit mots.

Comme représenté sur la figure 5, chaque mot comprend un en-tête 50 de cinq bits constitué par le nombre 11110. Ensuite, le mot comporte quatre bits 52 représentant la fonction du mot.

Dans l'exemple, les fonctions sont les suivantes : acquisition des données ou apprentissage ; véhicule à l'arrêt ; roulage ; diminution de pression ; pile(s) usagée(s).

Pour détecter que le véhicule est à l'arrêt ou est en cours de roulage, on prévoit dans la roue un capteur d'accélération couplé à l'émetteur. Lorsque l'accélération dépasse une limite prédéterminée, l'émetteur passe de la fonction arrêt à la fonction de roulage, et réciproquement quand l'accélération descend en dessous d'un seuil prédéterminé, l'émetteur passe de la position de roulage à la position d'arrêt. En position d'arrêt, l'émetteur transmet une trame une fois par heure. Par contre, en position de roulage, l'émetteur transmet une trame toutes les minutes dans l'exemple.

Un code 54 d'identification de roue s'étend sur 24 bits. Ce nombre de bits est nécessité par le fait que le code doit être particulier à la roue considérée afin que les mots transmis par un émetteur de roue vers le récepteur du véhicule, s'ils sont reçus par le récepteur d'un autre véhicule, ne soient pas interprétés comme correspondant à une roue de cet autre véhicule.

La valeur 56 de la pression est représentée par 8 bits.

Enfin, les deux bits 58 les moins significatifs représentent le code de vérification d'erreur.

## Revendications

1. Procédé de décodage, à bord d'un véhicule automobile, de mots numériques transmis par un émetteur solidaire d'une roue et représentant la pression du pneumatique correspondant, **caractérisé en ce que** l'émetteur produisant une suite déterminée de mots identiques, et chaque mot pouvant présenter une partie dégradée, on reconstitue le mot à partir des parties restées correctes des mots identiques (10₁, ..., 10₈) en soumettant à une opération OU logique les bits de même poids des mots d'une même suite de mots identiques.

2. Procédé selon la revendication 1, **caractérisé en ce que** le ou les chiffre(s) binaire(s) de la partie dégradée est (sont) à zéro.

3. Procédé selon la revendication 1 ou 2, **caractérisé en ce que** l'opération OU logique est effectuée avec le mot précédent à l'apparition de chaque mot décodé, le résultat de l'opération étant gardé en mémoire pour être soumis à la même opération avec le mot décodé suivant.

4. Procédé selon la revendication 1 ou 2, **caractérisé en ce que** les mots successifs sont gardés en mémoire et l'opération OU logique est effectuée sur l'ensemble des mots gardés en mémoire.

5. Procédé selon l'une quelconque des revendications précédentes, **caractérisé en ce que** les mots sont transmis en séquences ou trames séparées, chaque trame comportant un nombre déterminé de mots identiques séparés par des intervalles prédéterminés.

6. Procédé selon la revendication 5, **caractérisé en ce que** la détection des mots identiques est effectuée à partir des mots séparés par des intervalles prédéterminés.

7. Procédé selon la revendication 6, **caractérisé en ce qu'**un mot apparaissant après un mot précédent en un temps différent d'un intervalle prédéterminé est considéré comme le premier mot d'une autre roue.

8. Procédé selon la revendication 5, 6 ou 7, **caractérisé en ce que** le premier mot de chaque trame est utilisé pour synchroniser le décodage.

9. Système de détection de l'état de gonflage des pneumatiques d'un véhicule automobile dans lequel chaque pneumatique est équipé d'un capteur de pression et d'un émetteur **caractérisé en ce que** l'émetteur transmettant des mots numériques identiques représentant la pression du pneumatique, vers un récepteur à bord du véhicule, et le récepteur détectant le mot transmis à partir des informations redondantes émises par l'émetteur de la roue, pour le décodage, le récepteur comprend un dispositif pour reconstituer le mot à décoder à partir des informations correctes des différents mots reçus, cette reconstitution s'effectuant à l'aide d'une opération OU logique sur les bits de même poids de chaque mot reçu au cours d'une même séquence.

## Patentansprüche

1. Verfahren zur Dekodierung von digitalen Wörtern an Bord eines Kraftfahrzeugs, die von einem an einem Rad angebrachten Sender übertragen werden und den Druck des zugeordneten Reifens repräsentieren, **dadurch gekennzeichnet, dass** der Sender eine festgelegte Folge von identischen Wörtern erzeugt, wobei jedes Wort einen fehlerhaften Abschnitt aufweisen kann, und dass das Wort an Hand der fehlerfrei gebliebenen Abschnitte der identischen Wörter (10i, ..., 10₈) rekonstruiert wird, indem man die Bits gleicher Wertigkeit von Wörtern derselben Folge von identischen Wörtern einer logischen ODER- Operation unterzieht.

2. Verfahren nach Anspruch 1, **dadurch gekennzeichnet, dass** die Binärziffer(n) des fehlerhaften Abschnitts Null ist/sind.

3. Verfahren nach Anspruch 1 oder 2, **dadurch gekennzeichnet, dass** die logische ODER-Operation mit dem vorhergehenden Wort beim Auftreten jedes dekodierten Wortes durchgeführt wird, dass das Ergebnis der Operation gespeichert und derselben Operation mit dem nachfolgenden dekodierten Wort unterzogen wird.

4. Verfahren nach Anspruch 1 oder 2, **dadurch gekennzeichnet, dass** die aufeinander folgenden Wörter gespeichert werden und dass die logische ODER-Operation auf alle gespeicherten Wörter angewendet wird.

5. Verfahren nach einem der vorhergehenden Ansprüche, **dadurch gekennzeichnet, dass** die Wörter in getrennten Folgen oder Rahmen übertragen werden, wobei jeder Rahmen eine festgelegte Anzahl von identischen Wörtern umfasst, die durch festgelegte Intervalle voneinander getrennt sind.

6. Verfahren nach Anspruch 5, **dadurch gekennzeichnet, dass** die Erfassung der identischen Wörter mit Hilfe der durch festgelegte Intervalle getrennten Wörter erfolgt.

7. Verfahren nach Anspruch 6 **dadurch gekennzeichnet, dass** ein Wort, das zu einem von dem festgelegten Intervall abweichenden Zeitpunkt nach einem vorhergehenden Wort auftritt, als erstes Wort eines anderen Rades angesehen wird.

8. Verfahren nach Anspruch 5, 6 oder 7, **dadurch gekennzeichnet, dass** das erste Wort jedes Rahmens zum Synchronisieren der Dekodierung verwendet wird.

9. System zum Erfassen des Füllzustandes von Reifen eines Kraftfahrzeugs, bei dem jeder Reifen mit einem Drucksensor und einem Sender ausgestattet ist, **dadurch gekennzeichnet, dass** der Sender an einen Empfänger an Bord des Fahrzeugs identische digitale Wörter überträgt, welche den Druck des Reifens repräsentieren, dass der Empfänger das übertragene Wort an Hand von redundanten, vom Radsender übertragenen Informationen erfasst, dass zur Dekodierung der Empfänger mit einer Einrichtung versehen ist zur Rekonstruktion des zu dekodierenden Wortes an Hand von fehlerfreien Informationen der verschiedenen empfangenen Wörter, wobei diese Rekonstruktion mit Hilfe einer logischen ODER-Operation bezüglich der Bits mit gleicher Wertigkeit von jedem innerhalb derselben Wörterfolge empfangenen Wort erfolgt.

## Claims

1. A method, on board a motor vehicle, of decoding digital words transmitted by a transmitter secured to a wheel and representing the corresponding tyre pressure, **characterised in that** the transmitter produces a set sequence of identical words, each word may have a degraded part, and the word is reconstituted from the remaining correct parts of the identical words (10₁...10₈) by means of a logic OR operation on the equal-weight bits of the words in a given sequence of identical words.

2. A method according to claim 1, **characterised in that** the binary digit or digits of the degraded part are zero.

3. A method according to claim 1 or 2, **characterised in that** the logic OR operation is performed on the word preceding the appearance of each decoded word, and the result of the operation is stored and subjected to the same operation on the next decoded word.

4. A method according to claim 1 or 2, **characterised in that** the successive words are stored and the logic OR operation is performed on all the stored words.

5. A method according to any of the preceding claims, **characterised in that** the words are transmitted in separate sequences or frames, each frame comprising a set number of identical words separated by set intervals.

6. A method according to claim 5, **characterised in that** the detection of identical words starts from words separated by set intervals.

7. A method according to claim 6, **characterised in that** a word appearing at a time different from a set interval after a preceding word is considered as the first word for another wheel.

8. A method according to claim 5, 6 or 7, **characterised in that** the first word of each frame is used for synchronising the decoding.

9. A system of detecting the inflation of the tyres of a motor vehicle wherein each tyre is equipped with a pressure pick-up and a transmitter, **characterised in that** the transmitter transmits identical digital words representing the tyre pressure to a receiver on board the vehicle, the receiver detects the transmitted word on the basis of redundant information transmitted by the wheel transmitter for the purpose of decoding, and the receiver comprises a device for reconstituting the word for decoding from the correct information in the various received words, the reconstitution being made by means of a logic OR operation on the equal-weight bits of each word received during a given sequence.
